Europäisches Patentamt

European Patent Office

Office européen des brevets

(11) Publication number: **0 020 163**
A1

## EUROPEAN PATENT APPLICATION

(21) Application number: 80301807.6

(22) Date of filing: 30.05.80

(51) Int. Cl.³: **H 01 L 27/10,** G 03 G 15/00, G 03 G 15/044, G 03 G 15/048, G 03 G 15/22, G 03 G 15/32, B 41 J 3/16

(30) Priority: 30.05.79 US 43853

(43) Date of publication of application: 10.12.80 Bulletin 80/25

(84) Designated Contracting States: DE FR

(71) Applicant: XEROX CORPORATION, Xerox Square - 020, Rochester New York 14644 (US)

(72) Inventor: Ronen, Ram S., 207 Blanquita Way, Placentia California 92670 (US)

(74) Representative: Weatherald, Keith Baynes et al, European Patent Attorney c/o Rank Xerox Limited, Patent Dept. Rank Xerox House 338 Euston Road, London NW1 3BH (GB)

(54) **Monolithic HVMOSFET array.**

(57) Integrated monolithic arrays of high voltage metal oxide semiconductor field effect transistors are used in driver arrays, with on-chip logic and memory, on-chip writing styli and interconnects, to configure electrographic print heads or more particularly a silicon print head chip as a universal building block for electrographic printers.

- 1 -

## Monolithic HVMOSFET array

This invention relates to the field of semi-conductors and more particularly to metal oxide semi-conductor field effect transistor (HVMOSFET) high voltage driver arrays that may be switched.

Previously, high voltage devices tended to be discrete and could be set up in an array by hardwiring them together on a printed circuit board. Extreme care had to be taken in regards to proper separation of the intra-voltage breakdown with respect to the devices, and in addition, measures had to be taken to ensure that no fields from the high voltage devices interfered with the low voltage logic in adjacent areas. With the need to integrate such devices additional problem of a device switch for which it is desired to connect in cascade an active load thereto, but unable to due to the fact that with an outer common electrode, the output electrode is effectively grounded.

It is an important object of the invention to employ integrated monolithic arrays of high voltage metal oxide semiconductor field effect transistors (HVMOSFETs) with split oxide having closed device geometry whose periphery is grounded for use as switchable drivers able to source and sink non-steady state pulses; and

Yet another important object of the invention is to connect in cascade and concentricity an outer drive switch to an inner active load for formation of an integrated HVMOSFET switch.

The present invention will now be described by way of example with reference to the accompanying drawings, in which:

Figure 1 is a side half profile view of the HVMOSFET structure of the present invention;

Figure 2 is a side profile view of a graded junction for the HVMOSFET of Figure 1;

Figure 3 is a side half profile view of a no-offset structure for the HVMOSFET of Figure 1;

Figure 4 is a side half profile view of the electrode overlap structure for the HVMOSFET of Figure 1;

Figure 5 is a side half profile view of the SOS substrate for the HVMOSFET:

Figure 6 is a side profile view of the silicon structure for the HVMOSFET of Figure 1;

Figure 7 is an overhead profile slice view of the bulk silicon structure for the HVMOSFET of Figure 6;

Figure 8 is an overhead profile view of the isolated conductor structure for the HVMOSFET of Figure 1;

Figure 9 is a side profile view of the isolated conductor structure for the HVMOSFET of Figure 1;

Figure 10 is an overhead profile view of a concentric grounded periphery configuration for the HVMOSFET of Figure 1;

Figure 11 is a side profile view of the concentric grounded periphery configuration for the HVMOSFET of Figure 10;

Figure 12 is an overhead view of an array of HVMOSFET's of Figure 1;

Figure 13 is a side profile view of a single-poly non-overlapping gate structure as an alternative embodiment to the HVMOSFET of Figure 1;

Figure 14 is a side profile view of a double level poly overlapping discrete electrode structure as an alternative embodiment to the HVMOSFET of Figure 1;

Figure 15 is a side profile view of a single poly plus metal overlapping multiple electrode structure as an alternative embodiment to the HVMOSFET of Figure 14;

Figure 16 is a side profile view of a double level poly overlapping discrete electrode structure without insulation over the field plate as an alternative embodiment to the HVMOSFET of Figure 14;

Figure 17 is a side profile view of a HVMOSFET structure having doped rings for reducing services resistance as an alternative embodiment to the HVMOSFET of Figure 1;

Figure 18 is an overhead profile view of the HVMOSFET structure having doped rings as shown in Figure 17.

Figure 19 is a side profile view of a HVMOSFET structure having a doped region between gates as an alternative to the HVMOSFET of Figure 17;

Figure 20 is a side profile view of a HVMOSFET structure having a virtual drain structure as an alternative to the HVMOSFET of Figure 17;

Figure 21 is a side profile view of a HVMOSFET structure having doped rings for preventing a field line crowding as a alternative embodiment to the HVMOSFET of Figure 1;

Figure 22 is a view of a HVMOSFET driver connected in cascade to a HVMOSFET load a schematic embodiment to the HVMOSFET of Figure 1;

Figure 23 is an overhead view of a known device to accomplish the symmetric view of Figure 22;

Figure 24 is an overhead view of a device of the present invention to accomplish the schematic view of Figure 22;

Figure 25 is a schematic profile view of a HVMOSFET having a graded field plate as an alternative embodiment to the HVMOSFET device of Figure 1;

Figure 26 is a profile view of a HVMOSFET having a junction field plate as an alternative embodiment of the HVMOSFET device Figure 25;

Figure 27 is a profile view of a HVMOSFET having horizontal floating field plate as an alternative embodiment of the HVMOSFET device of Figure 1;

Figure 28 is a profile view of a HVMOSFET as an alternative embodiment of the HVMOSFET device of Figure 27;

Figure 29 is a profile view of a HVMOSFT having a ramp floating field plate as an actual embodiment for the HVMOSFET device of Figure 25;

Figure 30 is a profile view of a HVMOSFET having a semi-dielectric field plate as an alternative embodiment of the HVMOSFET device of Figure 25;

Figure 31 is a representative model of a HVMOSFET having oxygen doped polysilicon graded field HVMOSFET structure of Figure 25;

Figure 32 is a profile view of a HVMOSFET having separate voltages in the field plate as an actual embodiment of the HVMOSFET device of Figure 25;

Figure 33 is a profile view of a HVMOSFET having connectd voltages in the field plate as an actual embodiment of the HVMOSFET device of Figure 25;

Figure 33A is a profile view of a HVMOSFET having connectd voltages in the field oxide of the HVMOSFET device of Figure 25;

Figure 34 is a block representation of a single print head chip using the HVMOSFET of Figure 1;

Figure 35 is a schematic representation of the print head chip of Figure 34; and

Figure 36 is a block representation of an array of print head chips of Figure 34.

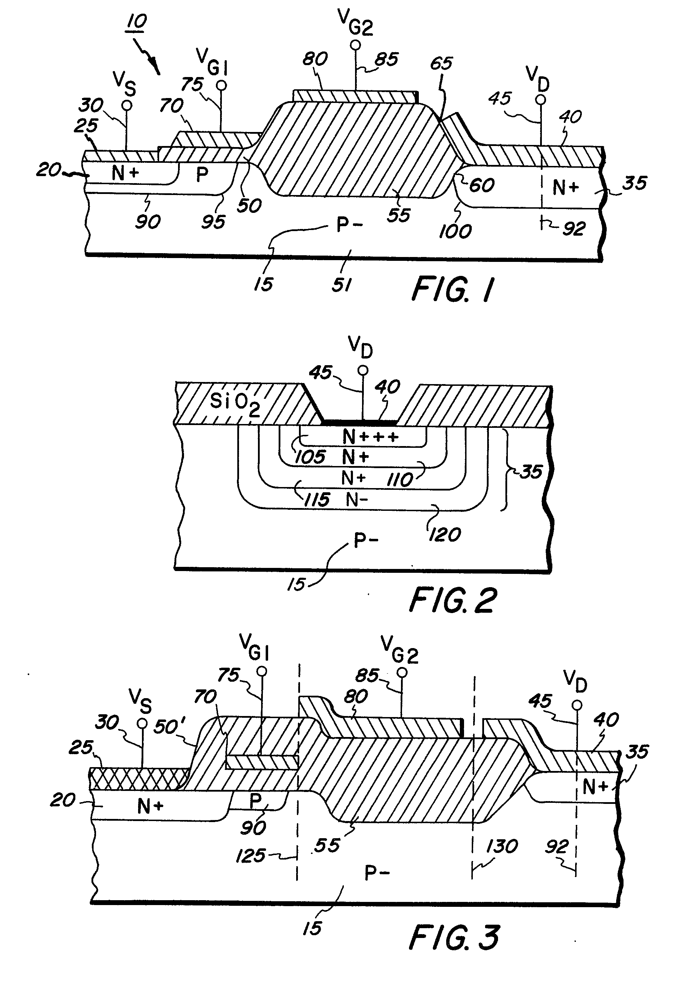

Referring to Figures 1 through 21 there is illustrated a high voltage metal oxide semi-conductor (HVMOSFET) structure or device 10 of the invention.

With reference to Figure 1, there is shown the basic HVMOSFET structure 10 in half side profile for use as a switchable driver which, in turn, is part of a monolithic integrated circuit array with substrate 15. The substrate 15 may be either P- or N-, or NMOS and PMOS technology, but is P- and NMOS in the preferred embodiment. Introduced into the substate 15 is a source area 20 that is N+ by implantation and is in proximate contact with a source plate 25 of metal on the surface of the substrate 15 which in turn is operatively connected to the source terminal 30 of metal. Also introduced in the substrate 15 is a high-voltage drain area 35 that is N+ by introduction including by implantation or diffusion and is in proximate contact with a drain plate 40 of metal on the surface of the substrate 15 which in turn is operatively connected to a drain terminal 45 of metal. Oxide is applied in contiguous thicknesses, that is a relatively thin or channel oxide 50, and a relatively thick or field oxide 55.

It will be appreciated that the separate channel 90 and drift region 51 constitute a DMOS-like structure. Because the substrate is P-, the channel 90 does not have to surround the source 20. The channel oxide 50 is applied over the surface of the substrate 15 adjacent to the source plate 25 whereas the field oxide 55 is applied into a recess 60 in drift region 51 and is relatively adjacent and spatially proximate to the drain plate 40 and to a height above the surface line of the substrate 15. Above the channel oxide 50 and proximate thereto is a first or low voltage control gate 70 of metal or polysilicon (poly) embedded therein for operation as an 'on-off' control element through terminal 75 of metal. It will be appreciated that this first gate 70 may in turn be embedded in oxide for better isolation. A second gate or high voltage field plate 80 of metal or polysilicon (poly) that is proximate to and above the field oxide 55 is operative to receive a voltage through terminal 85 of metal. It will again be appreciated that the field plate 80 may be embedded in oxide for better isolation. The channel 90, which is P type in the preferred embodiment, is a surface implant, except where the substrate 15 is N- in which case it also surrounds or is buried under the source area 20 thereby moving part of the channel 90 away from the surface as shown in Figure 1 which acts to control the threshold.

The relatively thin oxide 50 between the control gate 70 and the channel area 90 functions to enhance the gain with good rise/fall time, and lower the 'on-resistance or impedance (short condition) between source and drain areas 20,35 of the HVMOSFET 10. Correspondingly, in the 'off'(open) condition, it presents a high impedance from source area 20 to drain area 35. The relatively thick oxide 55 between the field plate 80 and the drift region 51 allows higher field voltages $V_{G2}$ and associated electrical fields as generated by the field plate 80, thereby precluding field inversion for a P-substrate to a greater degree than would be otherwise possible. It will be noted that in this embodiment $V_{G2} = V_D$, but alternatively with other

=

substrates $V_{G2}$ could be not equal to $V_D$.

Such HVMOSFET's 10 as described may be monolithically integrated into exemplary LSI cascaded arrays on a single chip of silicon and are thereby compatible with the fabrication processes in the MOS technology by which they are made. In particular, they may be simultaneously processed with conventional MOSFET's. The resultant HVMOSFET 10 is able to source and sink current pulses up to, and with proper geometry support, high steady state current. It will be appreciated that in such a HVMOSFET 10 driver that is switchable, driving into an impedance (not shown) may require an input from a voltage shifter (not shown) fed by low voltage (LV) logic (not shown) where the HVMOSFET 10, voltage shifter and LV logic may be all on the same chip hence requiring the very good isolation as described supra. It will be further appreciated in view of the above that the voltage shifter will drive the HVMOSFET 10 hard-on thus enabling operation with a relatively high threshold in regards to the HVMOSFET 10.

The N+ source area 20, P channel 90, first gate 70, and field plate 80 constitute rings around an axis of symmetry 92 at the center of the N+ drain area 35 thereby providing a closed device geometry for the HVMOSFET 10. This closed device geometry may take the form of a circle, square or similar topography constituting concentricity relative to the LV logic and voltages shifters on the same given chip. The closed geometry provides intraisolation within the HVMOSFET 10 and also inter-isolation on the same chip with respect to other devices. In particular with an N-substrate 15, inter-isolation is required. It will be also noted that in regards to isolation, the field plate 85 will surround the drain 35 on at least three sides with possibly a bracketing field oxide for the fourth side as noted infra.

As in most DMOS-like structures, the HVMOSFET 10 has a conventional junction breakdown surface 95 between the P channel 90 and drift region 51 for an N- substrate 15, or as in this embodiment, a junction breakdown surface 100 as between the drift region 51 and the N+ drain area 35 for a P- substrate 15. It will be noted that with an N- substrate 15 in a DMOS like structure for the HVMOSFET 10, VDS falls on the PN- junction surface 95 and thus into the channel 20. In such a case, the $V_{G2}$ of the field plate 80 would have to be negative to turn the drift area 51 off. In addition, inter-isolation relative to other devices would be required in such a case. Alternatively, in a P- substrate 15, the P- N+ junction or drain junction must be relatively deep which can be compensated for by inter-isolation with respect to the drain area 35.

The breakdown voltage of the drain area 35 can be increased while minimizing the curvature problem both mathematically and physically, which is to say, providing a linear junction rather than an abrupt one. This is carried out by providing a contact area that has been heavily doped to maximize current flow under a heavy 'on' condition. In particular, a multiple implant/drive profile is achieved by providing a graded junction at the drain consisting of by way of example, N+++105, N+ 100, N115 and N- 120 in the drain area 35 proximate to drift area 51 in the P- substrate 15 as shown in Figure 2. It will be noted that an incremental or discrete graded junction is shown in Figure 2, but alternatively, a continuously graded junction of doped material could be used.

Referring to Figure 3, in an alternative embodiment relatively very low on-resistance, as between source drain plates 29, 40 and relatively high speed switching operation as controlled by the first plate 70 may be desired. In some cases a no-offset structure, relative to the horizontal plane, might be utilized as shown in Figure 3. It will be appreciated that the plates of Figure 1 were relatively spatially offset. By way of example, thick field oxide 55 is used as above and also to the same level as in the thin channel oxide area 50, thus covering over the first gate 70 and part of the terminal 75 which is embedded therein. As indicated supra, there is no offset relative to the horizontal plane, and in particular as between the first gate 70 and the field plate 80 there is relatively no offset as shown by the dotted vertical line 125. Likewise, as between the field plate 80 and the drain plate 40 there is relatively no offset as shown by dotted vertical line 130.

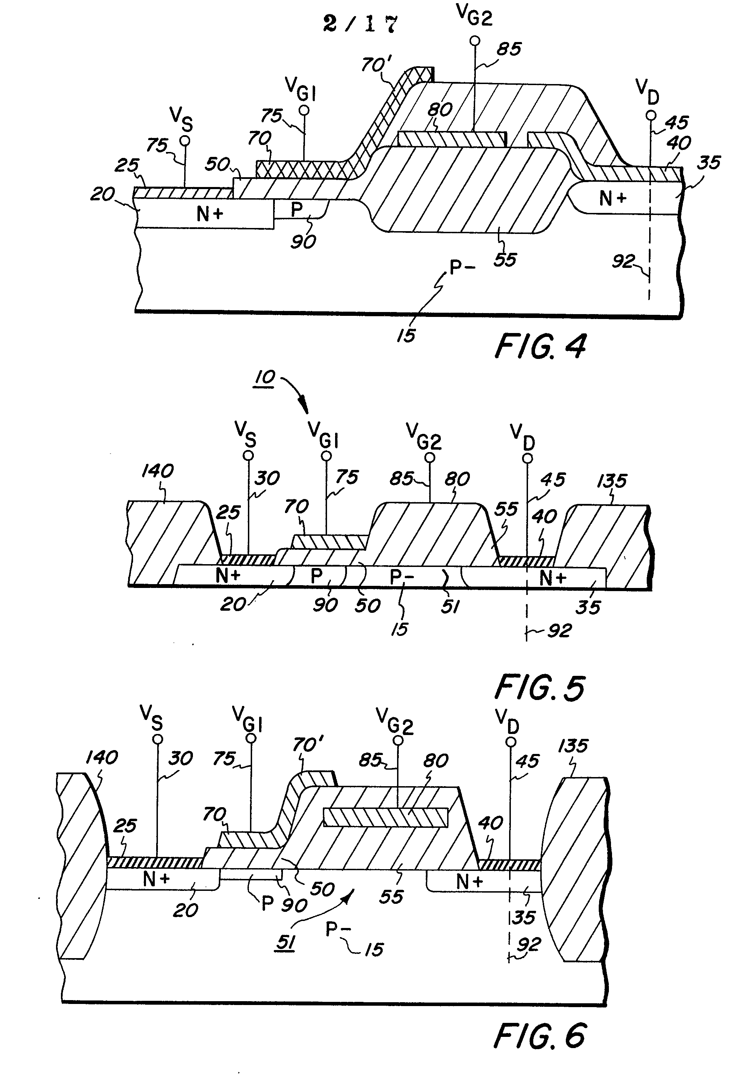

The same result as above may be had as shown in Figure 4, by overlapping the first gate electrode 70 in area 70' relative to the field plate or electrode 80 where the field plate 80 and part of the drain plate 40 are embedded in the thick field oxide 55. It will be noted in regards to the above that the lack of an electrode or plate overlap as in Figures 1 and 3 may result in higher on-resistance as between the source and drain plates 70, 40 which would be an undesirable condition in some applications. However, for most applications, the fringing fields from the various gates or plates are strong enough to modulate the surface 65 of the substrate 15 laterally.

In another alternative embodiment as shown in Figure 5, sapphire is used for the substrate 15 and the drift region 51 is introduced therein by implantation of P- or N- type material. The sides of the HVMOSFET device 10 are bracketed by field oxide ($SiO_2$) for isolation on either side 135,140. No silicon is present outside the active area. It will be noted that sapphire is a superior albeit expensive inter-device isolator.

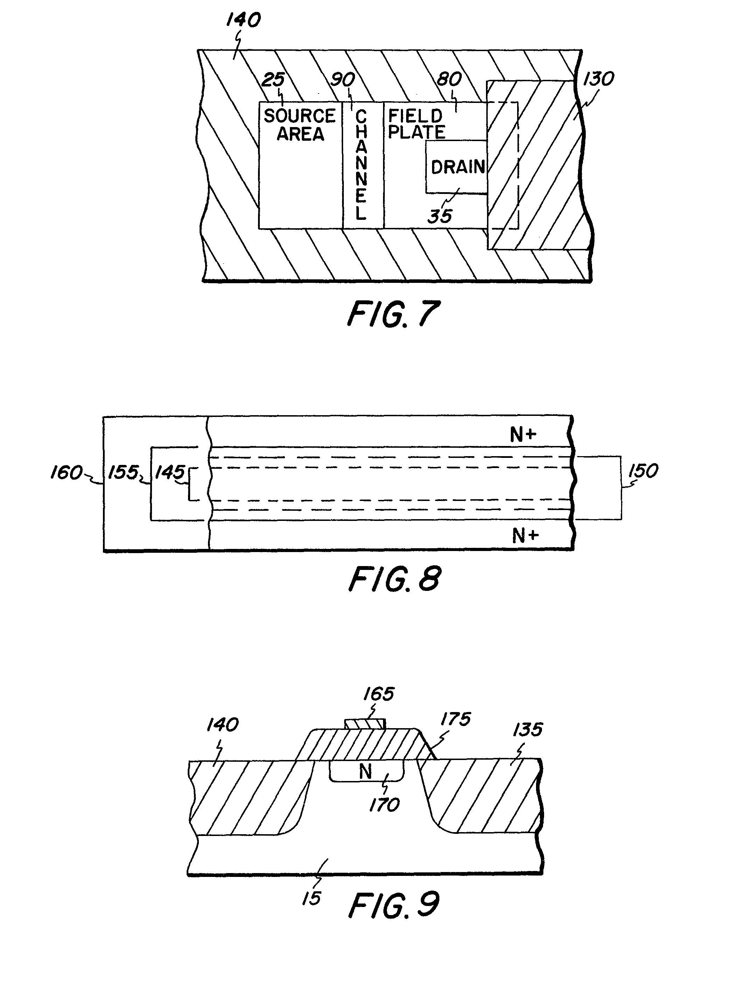

In yet another alternative embodiment as shown in profile in Figure 6 and in a top view of Figure 7, a HVMOSFET 10 with a bulk silicon substrate 15 is bracketed by $SiO_2$ sides 135 and 140 for isolation. Bulk silicon is relatively less expensive than sapphire as an isolator, but a degree less effective also.

In closed devices with the drain in the center such as a concentric structure, it is necessary to bring the high voltage lines or leads out from the terminals 30, 45, 75, 85 of the source plates 25, drain plate 40, first gate 70 or field plate 80 respectively without causing breakdown of oxide, excessive field inversion or Miller effects due to excessive capacitive admittance between input and output electrodes. In this embodiment the above problem is solved by routing high-voltage lines out on an oxide residing over a lightly doped area terminated by heavily doped areas on both sides for relatively excellent isolation of the HV lines from the HVMOSFET 10 itself as shown in Figure 8. As an example (as shown in Figure 8) a metal drain line 145 from drain terminal 45 is operative to have underneath it a silica layer 150 and underneath that undoped or P or N implant tailored material 155, and finally on either outer side of that may be bound heavily doped N+ silicon 60.

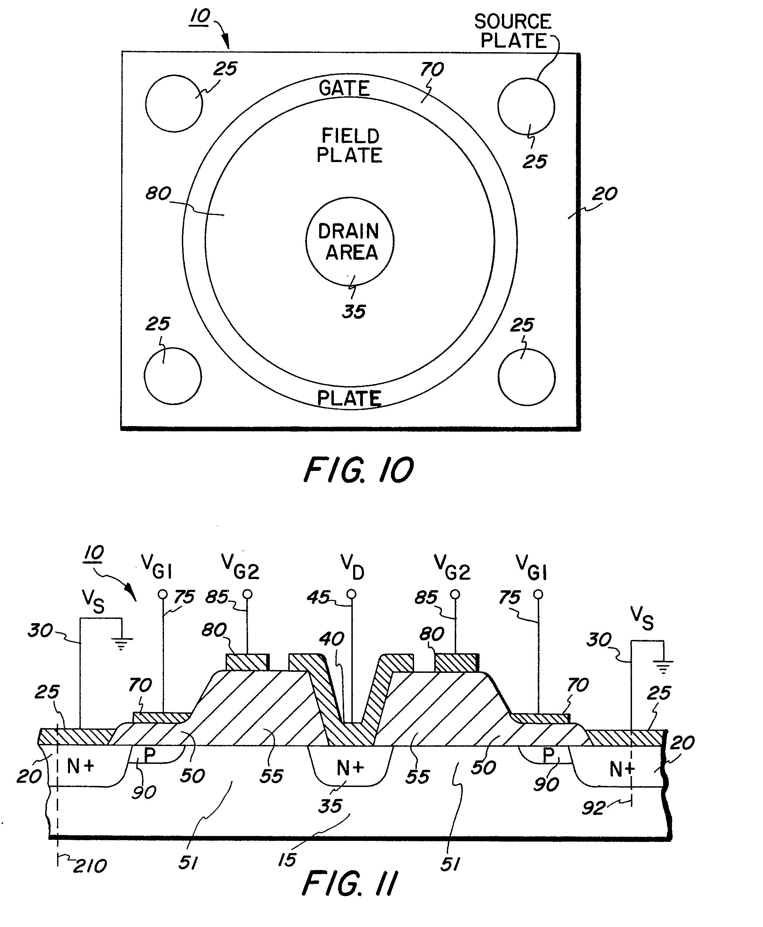

In regards to bringing a high voltage line 165 (Fig.9) or supra 145 over a lightly doped area 170, such as 155 as mentioned supra, it will be appreciated that it may be necessary to route high voltage lines 165 from the drain plate 40 and field plate 80 between bracketed field oxide 135, 140 or heavily doped silicon 60 mentioned supra and as shown in Figures 8 and 9. The field inversion problem or parasitic turn-on generated by the above may create a channel between the field oxides 135, 140, where each acts as a nonassociated diffused body in the field when high voltage passes over on the conducting line 165. The above may be alleviated, thereby containing HV electric fields and precluding inter-device coupling, by raising the conducting line 165 above the substrate 15 on a field oxide bed 175 and in addition, implanting an impurity 170 below the surface of the substrate 15. The lightly implanted area 170 in the embodiment is N, but could alternately be P implanted. With a lightly implanted N area 170, the implant may be completely depleted of carriers trying to accumulate at the surface of the substrate 15, thus significantly reducing the conductor 175, to substrate 15, parasitic capacitance. Alternatively with a P implant 170 a value for the N substrate 15 would be chosen to avoid surface inversion while only adding lightly to the capacitance of the line 165. Alternatively, the substrate 15 could be left undoped precluding area 170 to thus minimize capacitance under the line 165 for increasing the depletion region and decreasing the drive capacitance. It will be appreciated that, in the preferred embodiment and also in the alternative embodiments, N and P type implants may be reversed.

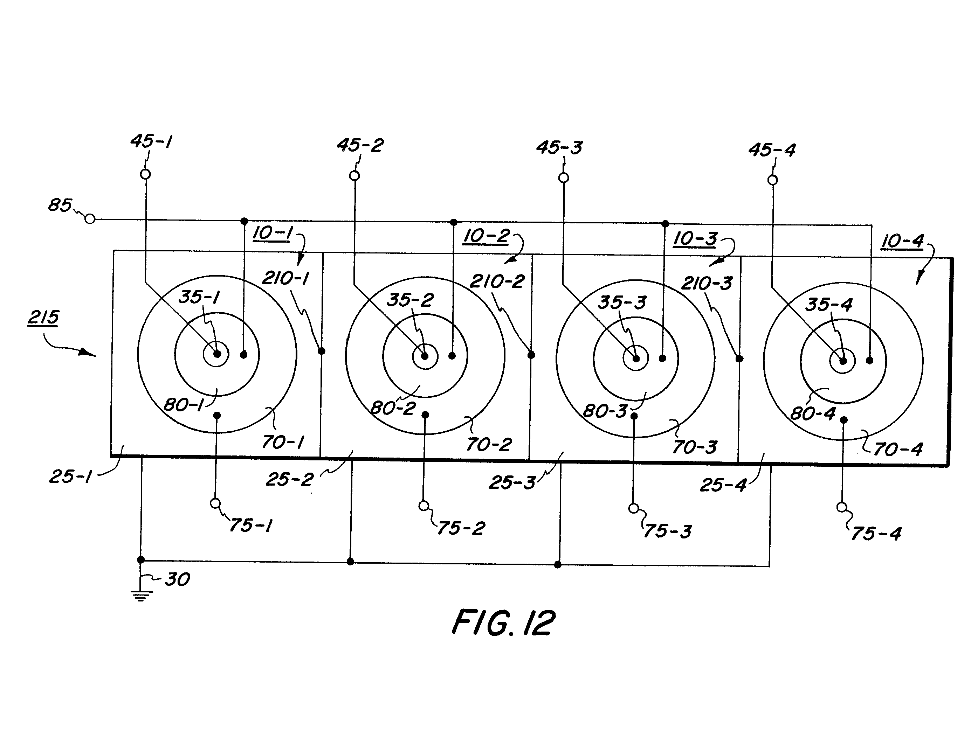

In an alternative embodiment as shown in Figures 10 and 11, the HVMOSFET 10 is shown in complete concentricity with the source electrode 30 grounded. This acts to solve the inter-device isolation problem by setting the periphery of the HVMOSFET device 10 at ground as is the substrate 15 thereby allowing neighboring devices to actually touch each other with relative impunity in regards to isolation.

It will be appreciated that by grounding the source area 25 as described and as shown in Figures 10 and 11, one can also have an axis of symmetry 210 relative to an array 215 of HVMOSFET devices 10 as shown in Figure 12 in addition to the axis of symmetry relative to the center of the device mentioned earlier. In particular, as shown in Figure 12, there is an array of four of the HVMOSFET devices 10-1 through 10-4. The array 215 has a common ground for the source terminals 30 from source areas 25-1 to 25-4, a common HV DC line for the field plate terminals 85 from field plate 80-1 to 80-4, separate LV lines for the central plate terminals 35-1 through 75-4, flow control plates 70-1 to 70-4 and separate HV outputs for the drain terminals 45-1 through 45-4 from drain areas 45-1 to 45-4. As shown there is an axis of symmetry 210-1 through 210-3 relative to the array 215 between each of the HVMOSFET devices 10- through 10-4 of the array 200.

The described grounded source area 25 on the periphery of each of the HVMOSFET devices 10 enables the above described symmetrical array 215. Specifically, it reduces fabrication costs by cutting the number of required loads as to the source area 25, increases the number of devices 10 per given area, and facilitates LSI and even VLSI integration of arrays of such devices on a monolithic chip.

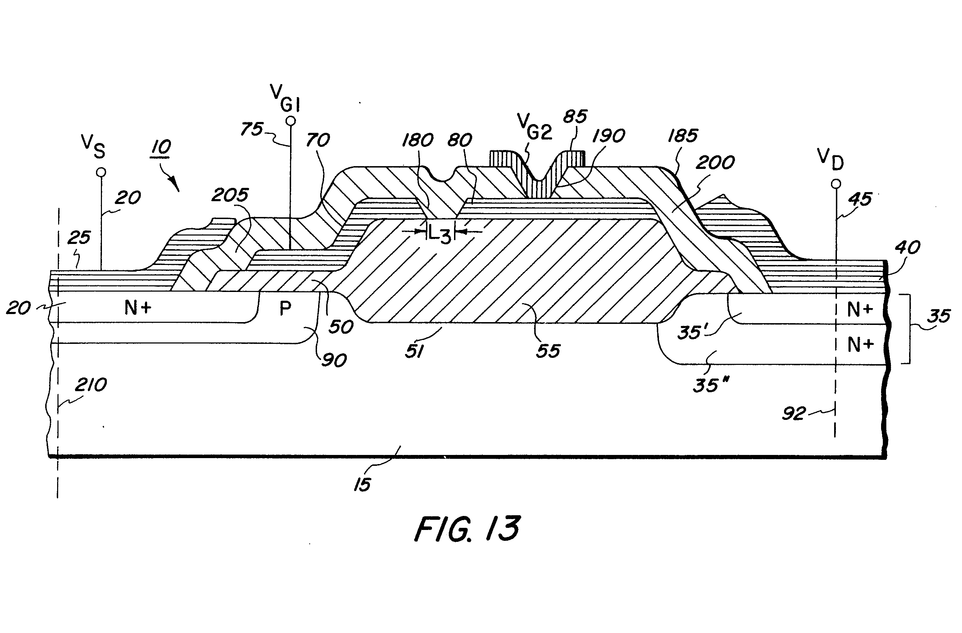

In an alternative embodiment as shown in Figure 13 a single polysilicon layer that is nonoverlapping is used as a modification to the _infra_ described HVMOSFET device 10.

In particular, a substrate 15 with p type is used having a drift region 51 therein, an implanted P type channel 90, an implant graded drain area 35 having a discrete N+ type subarea 35' and N type subarea 35". In addition, there is a relatively thick layer of field oxide 55 and a relatively thin layer of channel oxide 50 as described supra. The metal oxide is grown to form the thick layer 55 over the drift area 51. The channel 90 can be double diffused or defined by photolithograph and ion-implant. The metal or polysilicon (poly) layer for the first control gate 70 have LV applied voltage potential for turning on-off the HVMOSFET 10, and the second gate or field plate 80 having HV applied for bending field lines away from the drain area 35 may be deposited in a single layering process thereby precluding the expense and time needed for multiple level gates or plates having to be deposited in multi-layers. It will also be observed that the gates 70 and 80 do not overlap leaving unobstructed the field lines that may flow therebetween, in gap or space 180. Once the polysilicon layer comprising gates 70 and 80 is deposited, another or second layer 185 of oxide may be deposited for further inter-device field isolation. The source plate 25 deposited as a layer over the N+ source area 20 bounds the second oxide layer on one side, and the drain plate 40 deposited as a layer over N+ drain area 35 bounds the second oxide layer on its opposite side. An aperture 190 allows the electrode 85 deposited as a layer to make external electrical contact to the field plate 80. It will be noted that the voltage potential applied to gate 70 is a LV control potential. It will be further noted that there is overlapping spacing, this is, no overlap between gates 70 and 80, and plate 25, 40. Proper choice of spaces 180, 200 and 205 as between the gate and plates 25, 70, 80 and 40 is made so as to preclude field line crowding in the silicon, which is to say field drop rate between the plates and gates 25, 50, 70 and 80 is significantly less than the maximum permissible field, particularly in the silicon at the surface of the substrate 15.

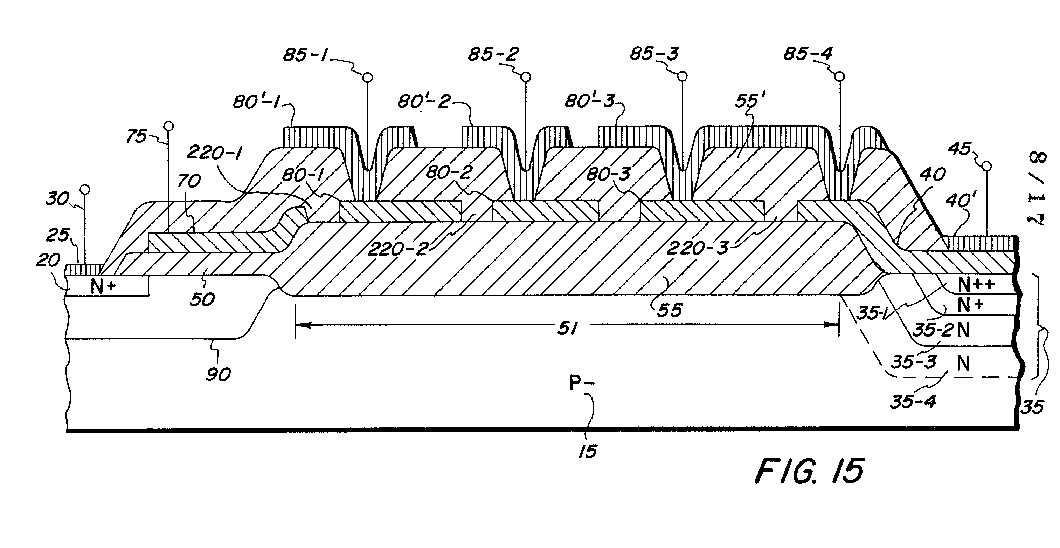

It will be appreciated that the gates 70 and 80 and in particular gate 80 need not be continuous, but rather may be in discrete multiples as in Figure 15 where the need arises to tailor the field lines 50 along the substrate oxide boundaries so as to evenly spread them out and stretch or bend them away from the drain area 35 thereby enabling a higher breakdown voltage thereat. Because there is no DC current into gates 70, 80, and in particular gate 80, they can be connected to a proportional polysilicon voltage divider (not shown) for the discrete divisions mentioned supra, so that the field plate potentials can be optimized.

The gap 180 between the two poly films or gates 70 and 80 can be minimized without avalanche setting in or causing a breakdown in the oxide 50 and 55. In addition, the drift field from field plate 80 to drain plate 40 can ensure proper injection into space 180 during an 'on' condition for the HVMOSFET device 10.

It will be appreciated that in the heavily "ON" mode for the HVMOSFET device 10, once the drain voltage applied to plate 40 has dropped enough, the fringe field at spaces 180 and 205 drops thus enabling those areas to actually simulate relatively large resistors or series resistance whose size is subject to the change on the surface of the substrate 15. This series resistance is not detrimental in that if for the capacitance in the spaces 180 and 205, the discharging of an external capacitor C, is completed in a relatively short time and thus is sufficiently low so that $R_s \cdot C$ is less than or equal to $T$, where $R_s$ is series resistance, C is capacitance, and T the time constant for a required discharge time. Once capacitance discharge is completed, $R_s$ may rise provided that $V_{on}$ is sufficiently low for the application. As indicated supra, it is necessary to overcome series resistance in the space between the overlapping plates and gates associated with HVMOS devices in an on-mode having large drift regions, specifically, the HVMOSFET devices 10 having drift regions 51. Inasmuch as prior art solutions involve complete processing with possible critical steps, such as relatively very narrow gaps or lightly doped rings, they cease to be economically or technically viable with higher levels of integration and voltage associated therewith.

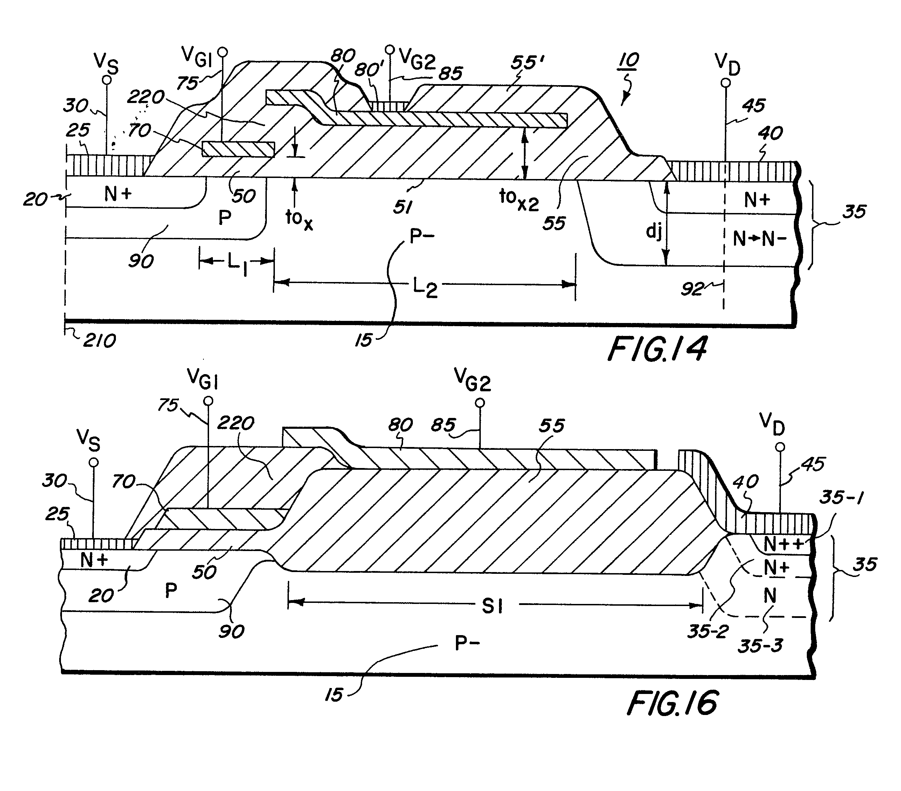

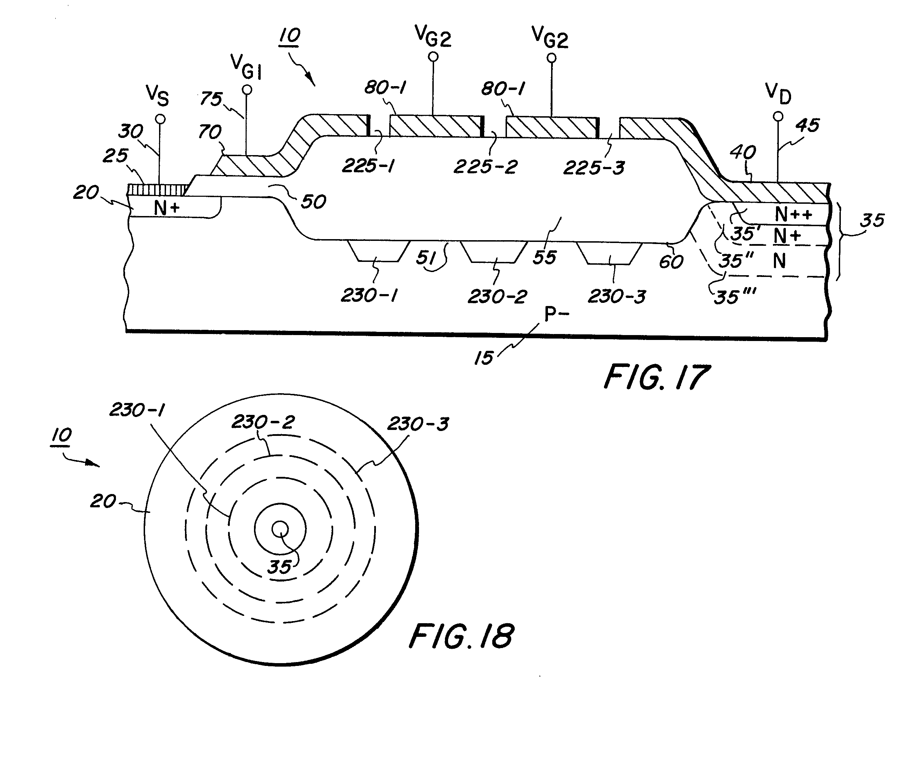

One proposed solution giving relatively high speed is the alternative embodiment     to fabricate HVMOSFET structures 10 with overlapping electrodes, and in particular, overlap the field plate electrode 80 relative to the gate electrode, as shown, in Figure 14. It will be appreciated that the above solution is equally applicable to devices 10 having discrete field plates 80 and gates 70 as shown in Figure 14 and 16, or alternatively devices 10 having multiple field plates 80 and gates 70 to further more finely tailor the field lines generated by the plate 80 thereby controlling and thus preventing bunching up of possibly destructive field lines therein the field oxide 55 as shown in Figure 15.

The above mentioned overlap may be achieved by double layer poly (or polysilicon) or by a polysilicon metal combination depending on the requirements of the technology.

The double level polysilicon overlapping region of the HVMOSFET 10 having discrete field plates 80 and gate electrodes 70 is shown in Figure 14. In particular, N+ source gate 20 having source plate (Vs) 25 of aluminum may be grounded through terminal 30. The P channel 90, shown as sweeping around the N+ source area 20, may be only a surface implant for a P-substrate 15 as shown. In any case, the surface dimension LI is 3.0 $\mu$m for double diffusion and 5.0 $\mu$m for defined ion implanted. It will be noted that there is an axis of array215 symmetry 210 adjacent to the source area 20.

The gate electrode 70 is at a relatively low voltage (LV) control potential in this embodiment as disposed over relatively thin channel oxide 50. The depth of the channel oxide 30 is about 1500A.The gate electrode 70 is polysilicon and is one of the above mentioned double layers. The field plate electrode 80 embedded in the relatively thick field plate oxide 55 is disposed to a depth      greater than or equal to 1.2 $\mu$m in the preferred embodiment. The field plate electrode 80 is comprised of polysilicon and is one of the double layers mentioned earlier.    Intervening between the field plate electrode 80 and the terminal (VG2) 85 is a metal plate 80' for the binding of each to the other. It will be appreciated that in this embodiment      field oxide 55' has been reflowed over the top of the field plate 80 for greater isolation. As indicated above a single or discrete field plate electrode 80 relatively overlaps a single or discrete gate electrode 70, but the total horizontal length of the field plate electrode 80 is L2 or 43 $\mu$m for breakdown

voltage between source area 20 and area 35 of 500V. It will be appreciated that this length coincides and correlates with the relative large drift area 51 mentioned earlier as between the source and drain area 20, 35. The drain area 35 or high voltage output interfaces with a drain plate 40 of aluminum metal that outputs through terminal($V_D$) 45. The drain area 35 is a graded implant similar to that mentioned earlier with a N+ subarea 35' nearest the surface and a N- subarea 35" having a combined overall depth that is greater than 5.0 μm or up to 10.0 μm for a multiple implant to eliminate curvature. As before the device 10" has an axis of symmetry 92 relative to the device 10 itself and an axis of symmetry 210 relative to the other devices 10 in the array 215.     The overlapping device polysilicon layer, where the field plate electrode 10 is the upper layer and the gate eletrode 70 is the lower layer, are fabricated to be laid down as separate layers where overlap is at space 220.

In Figure 15, there is shown a HVMOSFET structure 10 with multiple field plates 80-1 through 80-3 that sequentially overlap each other and the field plate 80-3 overlapping the single gate electrode 70. The multiple field plates 80-1 to 80-3 and gate electrode 70 are fabricated as a single level of polysilicon plus metal.

In particular, there is shown a N+ source area 20 with associated source plate 25 and terminal 30. In addition, there is a surrounding P channel area 90 with associate channel oxide 50 displacedbetweenthe channel 90 and gate electrode 70. The gate electrode 70 is composed of polysilicon and has applied there relatively LV control potential. In the P- substrate 15 is a relatively large drift area 51 for accommodating a relatively large breakdown voltage as between the source area 20 and drain area 35. As discussed before, the drain area 35 is graded to range from N++ (35-1) to N (35-4) for controlling curvature. Associated with the drain area 25 is drain plate 40 of polysilicon and an interfacing metal plate 40' of metal bonding it to terminal 45. Disposed between the silicon dioxide dielectrics 55 and 55' are the multiple field plate electrodes 80-1 through 80-3 of polysilicon.

The spatial overlap as between the multiple polysilicon field plates 80-1 to 80-4 and the single polysilicon gate electrode70 is provided by metal plates 80'-1 to 80-3 disposed above the field plates 80-1 to 80-3 and the drain plate 40. This overlap at spaces 220-1 through 220-3 acts to control the

- 14 -

high voltage field lines thereby minimizing the series resistance incurred in the spaces 220-1 to 220-3 during the on-mode for HVMOSFET 10,which in turn allows higher breakdown voltage in a large drift area 51. The metal plates 80'-1 to 80'-4 either all or in part with the exception of the drain plate 40, may provide HV DC to the field plate electrodes 80-1 to 80-3. It will be appreciated that in the above embodiment a single level of polysilicon was used in the fabrication of the field plates 80-1 to 80-3, the gate electrode 70 and the drain plate 40.

In an alternative embodiment for the HVMOSFET structure 10, as shown in Figure 16,having a single overlapping field plate 80 relative to a single gate electrode 70 with double-level polysilicon, there is an absence of field oxide 55' over the field plate 80 as was shown in Figure 14 and 15 as is feasible for a P- substrate 15 where isolation is relatively less of a problem then for a N- substrate, thereby obviating the cost required to implement such an oxide.

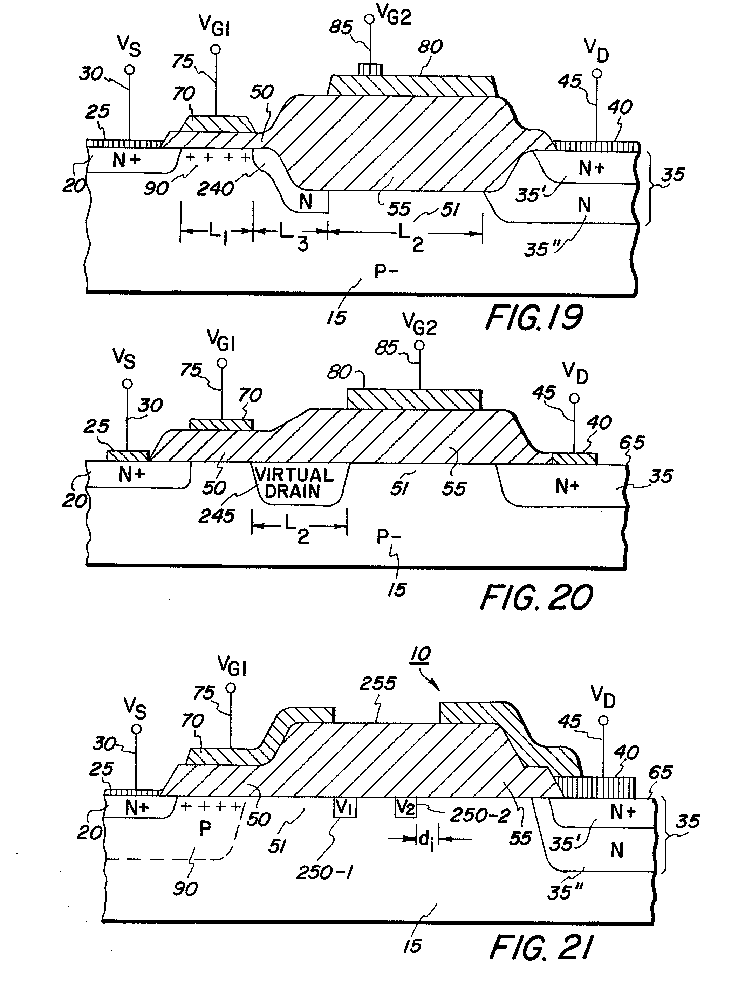

In regards to HVMOSFET structure 10 with gaps (225-1 through 225-3) between surface electrodes (70, 80-1, 80-2, 40) as shown in Figure 17, potential problems include overcoming fringing fields and series resistance. One possible remedy for the above includes doping the areas (230-1 to 230-3) between the field plates (80-1 to 80-2) gates and drain electrode (40) all of these being topographically rings or ring-like in closed geometry as shown in overhead profile in Figure 18.

The HVMOSFET device 10 analogous to those described above in regards to its remaining elements includes an implanted N+ source area 20 in a P- substrate 15 having a source plate 25 disposed above for connection to terminal 30. Likewise, an implanted drain area 35 having N++ 526 area 35', N+ 526 area 35' and N subarea 35" disposed below a drain plate 40 connected to a terminal 45. The split oxide in device 10 comprises relatively thin channel oxide 50 and relatively thick field oxide 55, both of silicon dioxide, and functions as a dielectric. The field oxide 55 is disposed in an indentation over a drift area 51 in the substrate 15 wherein the doped ring areas 230-1 to 3 are implanted. The gate 70,having a relatively low voltage control potential, is disposed over the channel oxide. The multiple or discrete field plates 80-1 with terminals 85-1 to 2 which could be alternatively continued while less field tailoring is required, are disposed over the field oxide 55. Gap 225-3 is interposed between drain plate 40 and field plate 80-1, and gate 225-3 is interposed between field plate 80-1 and gate electrode 70. It will be appreciated that there is correspondence between gap 225-1 and ring area 230-1, gap 225-2 and ring area 230-2, and gap 225-3 and ring area 230-3 respectively. The field plates 80-1 and gate 70 are single layer polysilicon.

Doping for the ring areas 230-1 through 230-3 includes N- doping to a relatively light degree so that when the drain area 40 field line collapses, the surface 60 of the substrate 15 is easily accumulated due to potential at surface 60 such that when the device 10 is 'off,' the drain 40 and gate 70 fringe field lines totally deplete these ring areas or regions 230-1 through 230-3. Alternatively, P or P+ region areas 230-1 to 3 may be used. In particular, in the "off" mode for the device 10, they will float to the appropriate potential at the surface 60. In the 'on' mode, the areas 230-1 to 3 will supply electrons thereby emulating a conductivity, but on the other hand not coupling through to gate 70.

In the above embodiment where the field plates 80-1 are separated from the drain plate 40, $V_{G2}$ greater than $V_D$ by at least one threshold for improvement of 'off' and 'on' modes for the HVMOSFET 10. It will be appreciated that by definition the field plates 80-1 and gate 70 are non-overlapping in this embodiment, and the gaps or spaces 225-1 to 3 from whence field lines flow through are disposed and correlate with the aforementioned ring areas 230-1 to 3 that are implanted in the drift area 51 of the substrate 15 to reduce on series resistance as between the field plates 85-1 to 2 and gate 70 by supplying an easy path to electrodes betwen the above points.

When the HVMOSFET device 10 is heavily ON and $V_D$ approaches zero by maintaining $V_{G2}$ greater than $V_D$, the ring areas 230-1 to 3 when implanted to N+ regions, will supply the needed electrons for continuity of the gated regions or spaces 25-1 to 3. It will be noted that the choice of concentration in the varied implants, constituting the ring areas 230-1 to 3, depends on the series resistance and overlap capacitance restrictions of the gates 225-1 to 3. In an alternative embodiment, to avoid coupling between field plates 80-1 and ring areas 230-1 to 3 doped as N+, the same areas 230-1 to 3 may be doped N type or, if buried effects are not a problem, then P+ type.

It will be appreciated that the gaps 225-1 to 3 will have to be relatively large to accommodate field lines and to prevent field avalanche due to crowding. As an alternative to using N type in the ring areas 230-1    N- or P type may be used in place thereof, thereby obviating, by way of example, the possibility of ring areas 230-1 short circuiting to the area 35 at the beginning of 'on' mode for device 10 where corresponding gap 225-1 may also attempt to short circuit.

In an alternative embodiment, to eliminate the series resistance in the gap 235, having horizontal dimension L3, due to insufficient drift field, the HVMOSFET device 10 as shown in Figure 19 may be used. The HVMOSFET 10 similar to above devices includes implanted N+ source area 20 disposed under plate 25 bonded to terminal 30 for $V_x$. Likewise implanted drain area 35 having N+ subarea 35' and N subarea 35" is disposed under drain plate 40 bonded to terminal 15 for $V_D$. The split oxide of silicon dioxide has channel oxide 50 and field oxide 55, where oxide 55 is disposed over drift area 51 in P-substrate 15 having lateral dimension L2 . An ion implanted channel regional 90 has a lateral dimension L1 . It will be appreciated that the implant for region 90 may be a blank implant after field oxide 55 is in place. Field plate or gate 80 having terminal 85 for $V_{G2}$ is disposed over oxide 55 and gate 70 having terminal 75 for $V_{G1}$ is disposed over oxide 50 where together they are fabricated as a single level of polysilicon.

A doped N type region or island between the two gates 70 and 80, having lateral dimension L3, is relatively highly doped with phosphorous or boron, acts as a source of electrons during the on condition for device 10 to reduce series resistance $(R_x)$ significantly. It will be appreciated that the amount of N doping at island 240 must be controlled to limit the level that the voltage at the N island 240 drifts during an 'off' mode thereby preventing the voltage from approaching $V_{G2}$.

In an alternative embodiment, a virtual drain structure with predetermined doping type and carier concentration for HVMOSFET 10 may be used as shown in Figure 20. The HVMOSFET 10 comprises a structure similar to those given above including an implanted N+ drain area 35 in P type substrate 15 disposed under plate 40 having terminal 45 for $V_D$. Likewise, implanted N+ type area is disposed under plate 25 connected to terminal 30.

Field plate 80 of polysilicon having terminal 85 for $V_{G2}$ is disposed over silicon dioxide that is relatively thick field oxide 55. In turn, the field oxide 55 is disposed over a drift region 51. Gate electrode 70 of polysilicon having terminal 75 for $V_{G1}$ is disposed over relatively thin channel oxide 50, the polysilicon being fabricated as a single layer. The new element in this alternative embodiment is a virtual drain 245 that may be N+ with heavy phosphorous giving an analogous cascade structure. Specifically, while the device 10 is in the 'on' mode, the virtual device 215 helps injection of electrons in the drift region 51 which is inverted. In contradistinction, when the device 10 is in an 'off' mode, the virtual drain 245 will float to within one threshold voltage of the second gate or field plate 80, i.e. $V_{G2}$- $V_{T2}$. This will cause a small voltage to drop across L2, the lateral spatial dimension for virtual drain 245, instead of the entire voltage. Accordingly, if the doping of the virtual drain 245 using P type is not strictly controlled, the HV aspects of the device 10 will be obviated thereby causing it to simulate a LV cascade structure. With this in mind, alternative embodiments that would require less process control than that described above include making the virtual drain P dope. Thus in the device 10 'off' mode, the virtual drain 245 would not float to $V_{G2}$-$V_{T2}$ as described above: if not strictly controlled and in an on mode the virtual drain 245 would emulate a conductor better than when completely undoped. Alternatively, once could obviate the virtual drain 245 completely and rely strictly on the drift field. Alternatively, one could dope the virtual drain 245 relatively lightly to be N type, so as to be almost intrinsic, so that under sufficient voltage of $V_{G2}$ the virtual drain 245 would deplete during the 'off' mode for device 10. Alternatively, one could bury a channel (not shown) relatively light in N type relatively deep in the substrate 15. This would function especially well when $V_D$ equals $V_{G2}$ because when $V_{G2}$ collapses, the surface 65 of the substrate 15 will not be depleted and thereby conduct relatively heavily.

It will be noted that when the goal is to reduce series resistance in a HVMOSFET 10, other possible alternative embodiments include doped ring areas 230-1 that are off-set to each other, but electrically connected (not shown); multiple ring areas 230-1 each with independent field voltages (not shown), and tailored doped rings 230-1 to get a uniform field drop in the lateral direction, that is from drain area 35 to source area 0. It will be noted that by tailoring the potential profile of the surface 65 from drain area 35 to source area 20, no crowding of field lines will occur. In addition, it will be particularly noted that no high fields will appear across the field oxide 55 thereby preventing electron injection, oxide charging and instabilities.

In the HVMOSFET structure 10 where the need is critical to spread out the field-lines relative to the drain area 35, so that field crowding does not occur, and in addition, adjust field potential lines so that they are perpendicular to the dielectric or field oxide 55, then the use of field plates 80 may be suboptimal in such an environment. As an alternative, as shown in Figure 21, the use of doped rings 250-1-2 around the drain area 35 along the surface of the substrate 15 can stretch out the field lines while at the same time not adding significantly to the series resistance in the 'on' mode of the device 10. According to a HVMOSFET structure 10 as shown in Figure 21 may be implemented to include such rings 250-1 and 2 comprising a N+ source area 20 implanted in the substrate 15 with a source plate disposed over the area 20 and is externally electrically connected through terminal 30 at $V_S$. Likewise, N+ drain area 35 is implanted in substrate 15 with a drain plate 80 disposed on the area 35 and is externally electrically connected through terminal 45 having $V_D$. The drain area 35 is graded into subareas with N+ 35' through N35". It will be noted that $V_1$ is the potential of doped ring 250-1 and $V_2$ is the potential of doped ring 250-2. The field oxide has relatively thin channel oxide 50 of silicon dioxide of dielectric disposed over an implanted P channel area 90 that surrounds N+ source area 20. Disposed over the channel oxide 50 is relatively low voltage potential control gate electrode 70 embedded in the surface thereof for turning 'on-off' the HVMOSFET 10. In addition, a relatively thick field oxide 55 of silicondioxide as a dielectric disposed over a drift area 51 in the substrate 15. Disposed partially over the field oxide 55 is a continuation of the drain plate 40. The doped rings 250-1 and 2 are implanted in the surface 65 of the substrate 15 in the region of the drift area 51 and are relatively offset as to each other and also as to the gate electrode 70 and the drain plate 40. As indicated above the use of field plates 80 has been obviated in this embodiment by the use of the doped rings 250-1 and 2, thereby leaving a gap 255 on the surface of the field oxide 55 between the gate electrode 70 and drain plate 40.

It will be appreciated that carrier concentration in the rings doped on the substrate 15 are related to the desired field profile and the field oxide 50. In particular, the desired field profile, in turn, is dependent on drain voltage $V_D$ on terminal 15, spacing of the deposed rings 250-1 and 2 should be accumulated when the device 10 is conducting in the 'on' mode and totally depleted when the drift region 51 has to support the high drain $(V_D)$ to source $(V_X)$ voltage in the 'off' mode. Accordingly, to prevent surface breakdown of junctions as in the source and drain areas 20 and 35, multiple rings 250-1 and 2 of doped silicon under the surfaces may be used to keep the field lines from bending in towards the junctions or other perimeter of the source and drain areas 20, 35.

In the application of doped rings 250-1 and 2 to HVMOSFET structures 10, certain conditions must be met. In particular, the rings 250-1 and 2 must be doped below degeneracy. In the 'off' mode, the structure 10 will support relatively high voltage. In the 'on' mode of the device 10, the rings 250-1 and 2, which are floating at $V_S$ greater than $V_1$ greater than $V_2$ greater than $V_D$), will start to drop in potential. However, as long as their potential is higher than the neighboring or adjacent surface 65 of the substrate 15, injection and collection will take place.

In the above embodiment of using doped rings 250-1 and 2 in place of field plates 80, the doped rings 250-1 and 2 cannot be placed proximate to or under any plate such as the drain plate 40 at a higher potential from the floating potential than is required to sustain an overall HV breakdown. If this condition is violated, the doped rings 250-1 and 2 float to within a threshold voltage $(V_{TH})$ of the corresponding field plate the potential or drain plate potential 40. The horizontal spacing or gap (1) between the doped rings 250-2 and the corresponding plate such as drain plate 40, has to be greater than the coupling distance.

The doping in rings 250-1 and 2 is chosen for optional shaping for the field lines which is to say as indicated above, to prevent field crowding and allow perpendicular adjustment relative to the dielectric oxide 50. The rings 250-1 and 250-2 may be doped N- and P-, or even N and P, when compensated, resulting in a net doping needed for HV breakdown.

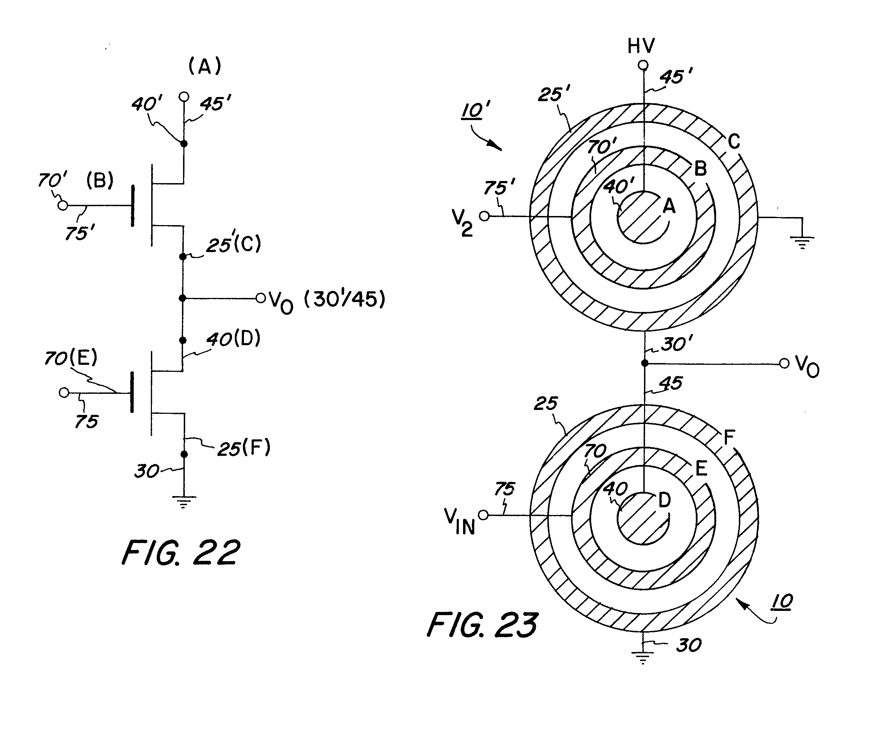

In an alternative embodiment for an array, there is a need to monolithically integrate the HV driver 10 and associated active load 10' to be connected in a cascade mode to form a complete high voltage switch 10/10'. In the prior art, active load 10', that is a transistor, when they are both on the same substrate, and have one electrode common with the substrate, e.g. common source. Independently in a conventional HVMOSFET 10, as shown in overhead profile in Figure 10 and in side profile in Figure 1, the high voltage electrode or drain area 35 is in the center and the surrounding grounded electrode or source 30 is common to the substrate 15 with control gate 70 and field plate 80 intermediate thereto. When such devices 10 are in an array, cascading such devices as driver 10 and load 10' together, as shown in overhead view Figure 23 and schematically in Figure 22, does not form a HV switch. Connecting the HV devices 10 in cascade, where there is a common source 30 or drain 45, results in a common output unless the load transistor 10' is independently isolated from the substrate 15. Rather what happens is that the output electrode, Vo (30'/45), is connected to the source area 25' in the load device 10' which is a common electrode. Hence, it cannot rise above such source voltage (Vs) and in fact remains essentially at ground potential. As it happens, the same          is true for a cascade connection of any two devices the high (drain) or low (source) voltage, electrodes that are in common with the   substrate 15.                              It will be appreciated that $V_{G1}$ on line 75 is the input voltage whereas $V_2$ on line 75 may be connected to its drain, source or control device for active control push-pull.

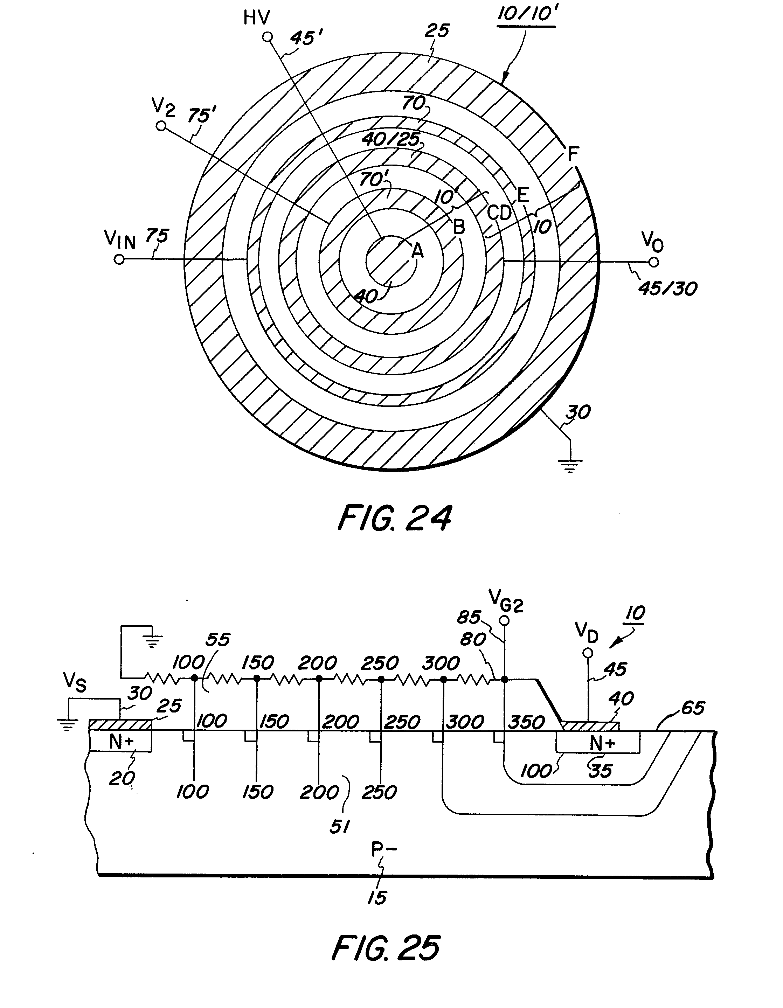

To overcome this problem, the HVMOSFET structures in Figure 24 is shown.  In order to form an integrated high-voltage switch, two high-voltage devices 10 and 10' are configured concentric to one another. Hence the fixed potential high voltage electrode ($V_2$) 70', the output electrode ($V_o$), 40/25', and the input electrode (Vin) 70, are in a monotonical decreasing voltage order from the center 40' out. Specifically, this is shown in Figure 24 using the letters A through F. While the driver device 10 (F-E-D) can be a HVMOS of the type disclosed above, the load device 10' (A-B-C) can be the same device or another HVMOS with different characteristics, that is, lower gain, higher-impedance, or higher-voltage breakdown between gate and source.

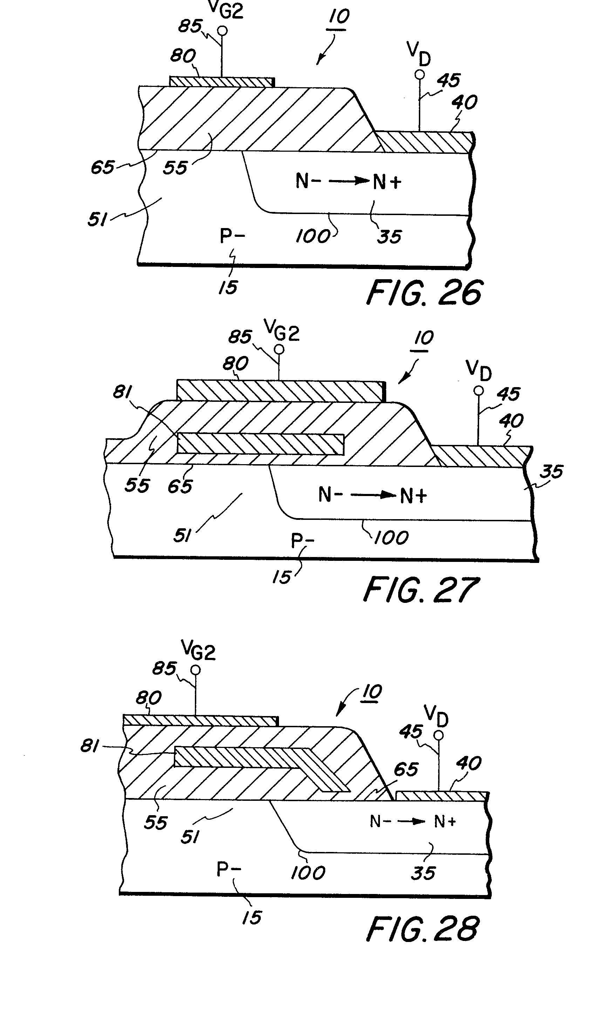

It will also be noted that the concentric device 10/10' as shown in Figure 26 is circular, but need not be.    In fact it may alternatively be oval/elliptical to increase gain and decrease resistance.    Although this device10/10' is larger than a simple HVMOSFET driver device 10 as described supra, it is integratable, and forms a complete high-voltage switch 10/10'. Moreover, it may be used with an active load 10' on line ($V_2$) 75 such as an electrographic printer, or an ink-jet driver.

It will be further appreciated that the device 10/10' may have relatively thick oxide 55 deposited on and above it both as to the driver device 10 and load device 10' without any field plates 80, or alternatively, only thick oxide 55 on the load device 10' without field plate 80 and split oxide 50/55 on the driver device 10.

In an alternative embodiment as shown in Figure 25, by grading the applied field plate 80 and tailoring it to match the field lines due to HV at the junction 100 of the drain area 35, one can extend breakdown voltage as between the source and drain areas 20, 35, to minimize BV across the thick or field oxide 55 thereby enabling a self-contained HV device. In particular, the field plate 80 when connected to drain area 40 may be incrementally graded from $V_O$ to ground.

Among the subembodiments thereof as shown in Figure 26, includes placing a field plate 80 over the junction 100 to deplete the material of the substrate 15 and bend the field lines away from the drain at the surface 65 and the junction 100. In such a case, the chosen field plate voltage ($V_{G2}$) on terminal 85 may be greater than the drain voltage ($V_D$) on terminal 45.

In another subembodiment thereof, as shown in Figure 27, an additional floating field plate 81 is interdisposed between the field plate 80 and the surface 65 so that hot carriers can be injected into it by the field plate 80 and thereby minimize the field thereabout in the oxide 55. The floating field plate 81 should either be of polysilicon (poly) or a proper refractive metal such as tungsten or molybedenum.

In yet another subembodiment thereof, as shown in Figure 28, the floating field plate 81 may be a lipped annulus in configuration thereby allowing tunnelling to occur at the drain area 35 and not over the junction 100 or the drift region 51. As the floating field plate gets further from the drain area 35, the oxide 55 underneath has to support a relatively higher field in the off condition for the device 10.

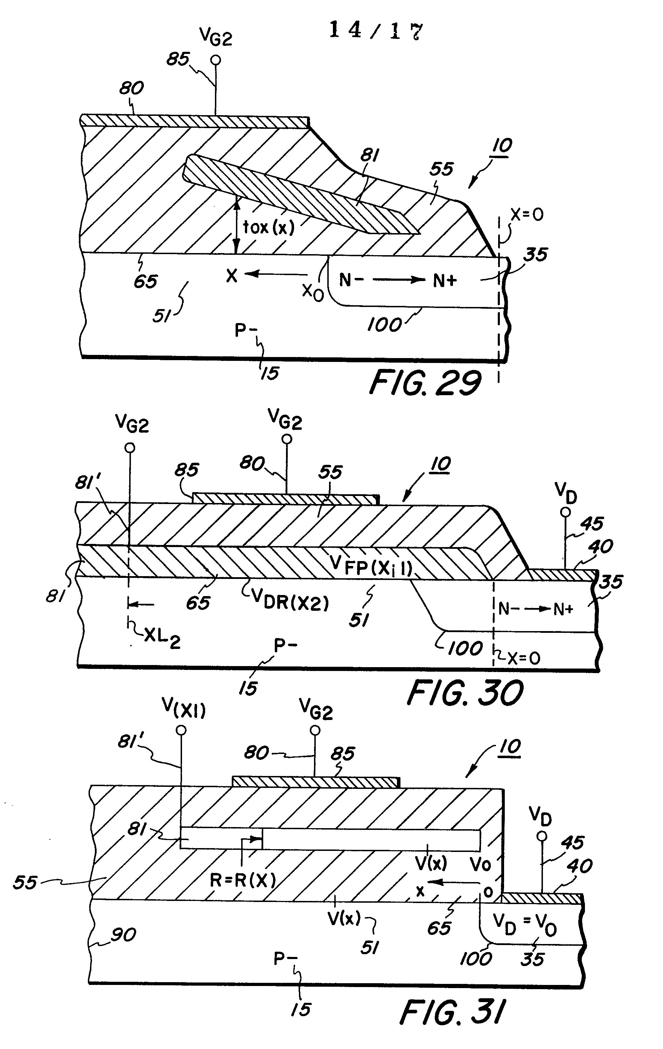

In yet a further subembodiment thereof, as shown in Figure 29, a frustoconical electrode 81 is positioned in oxide 55, with its distance to $(X-X_O)$ from surface 65 (tox(x)) being proportional to prevent destructive oxide breakdown.

In another further subembodiment thereof, as shown in Figure 30, to prevent hot electrons from becoming a reliability problem, a slightly conductive layer, such as a floating field plate 81, can replace the oxide 55 using SiO2 or Si3N4 over the junction 100 and drift region 51. The plate 81 may be a semiinsulating polysilicon SiPOS such as oxygen doped polysilicon. The oxygen doped poly for the plate 81 can be put in direct contact with the surface 65 of the P-silicon substrate 15 or alternatively over a relatively thin oxide (not shown). Because of the plates 81 finite though relatively low conductivity, it may act as a very high resistance field plate 81, thereby avoiding the problem of hot electron injection and trapping in the oxide 55 near the drain area 35 as mentioned above At the same time, the plates 81 relatively low conductivity can allow getting up a field at the surface 65 that is relatively almost perpendicular at the surface 65. As shown in Figure 31, to ensure a slow field drop and relatively perpendicular field lines at the surface 65 (equipotentials), an electrode 81' is connected to the semi-insulator plate 81 at X equals XL2, and the voltage at that point VGL is set up so that VFP (Xi) is greater than or equal to VDR (Xi).

It will be noted that by combining a relatively highly resistive plate 81 over the junction 100 and drift region 51, one can reduce tangential field components at the surface 65. Specifically, one can minimize (field potential) lines that cause crowding at the surface 65. In addition, combination of oxygen doped polysilicon or similar very high resistance material at plate 81 and a geometry factor/shape makes the lateral field drop from the drain area 35 to the channel (90) equal to the resistance drop in the SiPOS plate 81. Assuming a depletion region voltage drop of E(X) equals E (O) - 9NaX/ESi, where Na and ESi are constants for a given substrate 15 type, and the potential distribution is $Q(X)=VO((1-X)/X)^2$, where XO=X(Q=O). It will be noted that by making R(X) proportional to VX , it is possible to have a potential distribution in an R of the depletion region. In addition, by adjusting R(X), XO and V(XI) where

$V_{G2}$ equals V(X1), one can adjust the field lines and voltage drops to eliminate local crowding and local avalanche. Likewise, a step at VO(X1) can help invert the surface 65 of the substrate 15 more quickly.

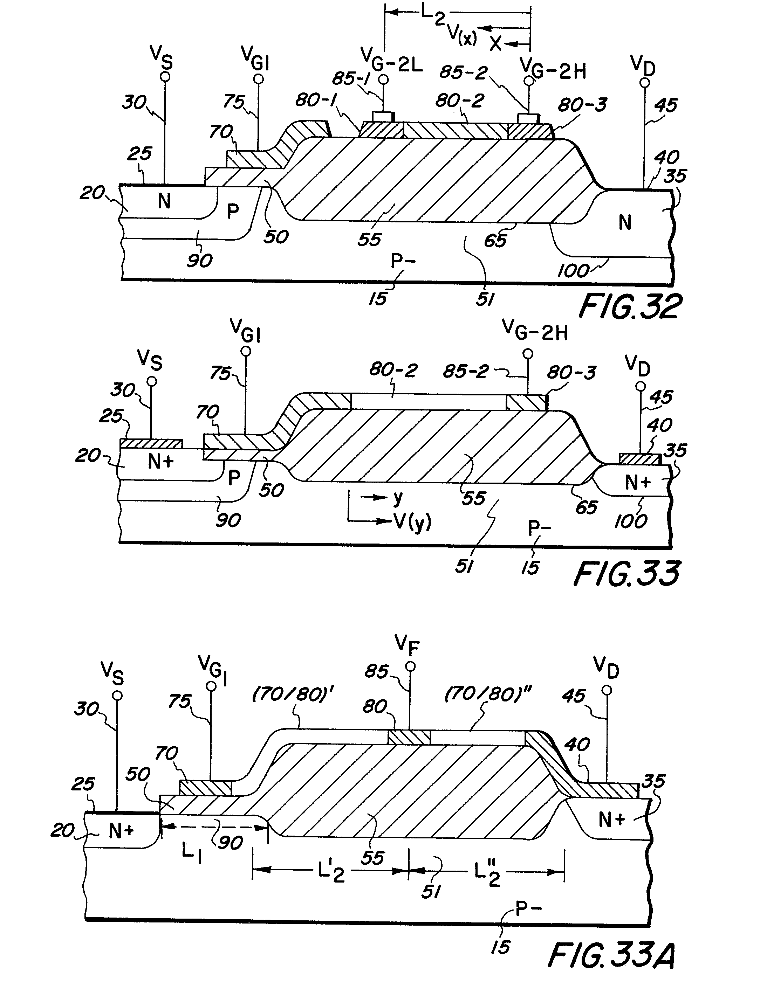

In regards to a profiled field high voltage MOS structure 10 as shown in Figure 32, it will be appreciated that instead of using several field plates 80 or multiple rings 230 as described above one may use a resistive gate material doped at either end (80-1 and 83) and undoped in the middle (80-2) for field plate 80. Applying separate voltage $V_{G2}L$ (85-1) and $V_{G2}H$ (85-2) will result in a voltage drop along along the lateral dimension of the field instead of a constant field voltage $V_{G2}$. By appropriately choosing L2 which is the field plate length (80-1 through 3), and also it·s geometrical shape, one can change the shape of the field lines at the surface 65. In fact, by choosing L2 and V(X) so that S(X), the surface 65 potential due to field lines from drain area 35 and the field plate 80-1 to 3, are perpendicular to the surface 65, several problems are solved. Mainly; the breakdown voltage becomes that of a plane junction, the field across the oxide 55 is orthogonal to the surface 65 and therefore minimal thereby minimising injection into the oxide 55 and other long term instabilities; device 10 structure simplification is realized; and finally, the lateral potential can be tailored exactly. A further modification of the above concept could include connecting the two gates or control gate 70 and field plate 85 thereby eliminating $V_{G2}L$ (80-1.

In particular, it will be noted that continuing the above concept in regards to a proportional field plate voltage distribution having a resistive gate as shown in Figure 33, by making the first or control gate 70, VG1 heavily doped poly and the same for $V_{G2}H$, and the field plate 80-2 lightly doped, a voltage drop V(X) can be achieved. When the first gate 70 is approximately zero the device 10 is 'off', V(X) equals $V_{G2}H$ X, depending on the geometry where 0 is less than or equal to V(X) which is less than or equal to $V_{G2}H$. When the device 10 is turned 'on', VG1 goes to VG1H and VG1H is less than or equal to V(X) which is less than or equal to VG2H because VG2H is much greater than VG1H (that is 500V versus 12V), and the power distribution accordingly in the gate 70 doesn't change much. In addition, because the edge of VG2L is not fixed, the changes in potential help or both the 'off' condition and the 'on' state (lower RS) for the device 10.

Variations on the above concepts could include SiPOS and doped rings to improve the field distribution. In particular, surface geometry other than circular or rectangular could be used to give $V(X)$ other than perpendicular or linear.

In addition, surface resistors or contact points to undoped poly act to further tailor $V(X)$ to match supra $S(x)$ IN A DEPLECTION REGION. Also in addition, doped and undoped poly could be mixed as rings of undoped poly and doped poly.

In figure 33A, an alternative embodiment is shown having a HVMOSFET device 10 with a graded potential field plate structure with an interim fixed potential, $V_F$ substitutes for $V_{G2}$ and connecting undoped areas (70/80)' and (70/80)". In the 'off' mode, the voltage drops are $(V_D - V_F)$ along L2" and $(V_F)$ along L2'. In the 'on' mode $(V_D - V_F)$ equals approximately minus $V_F$ for L2" and $(V_F - V_{GI})$ equals approximately $V_F$, where typically $V_{G1}$ is less than ten volts, and $V_F$ equals approximately one hundred to two hundred volts.

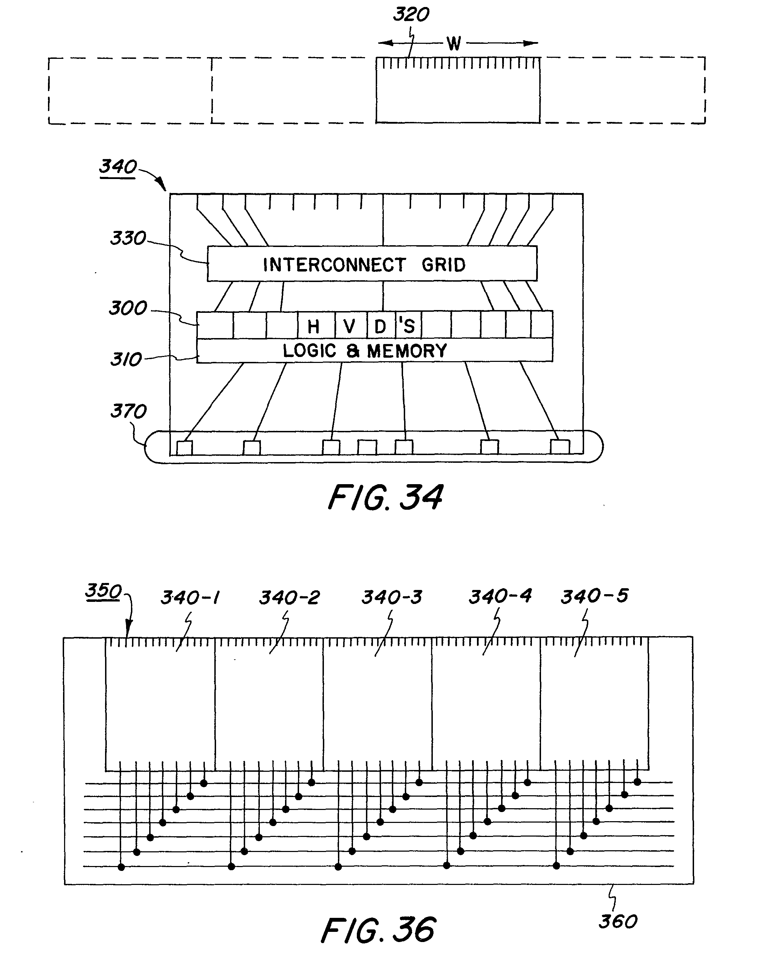

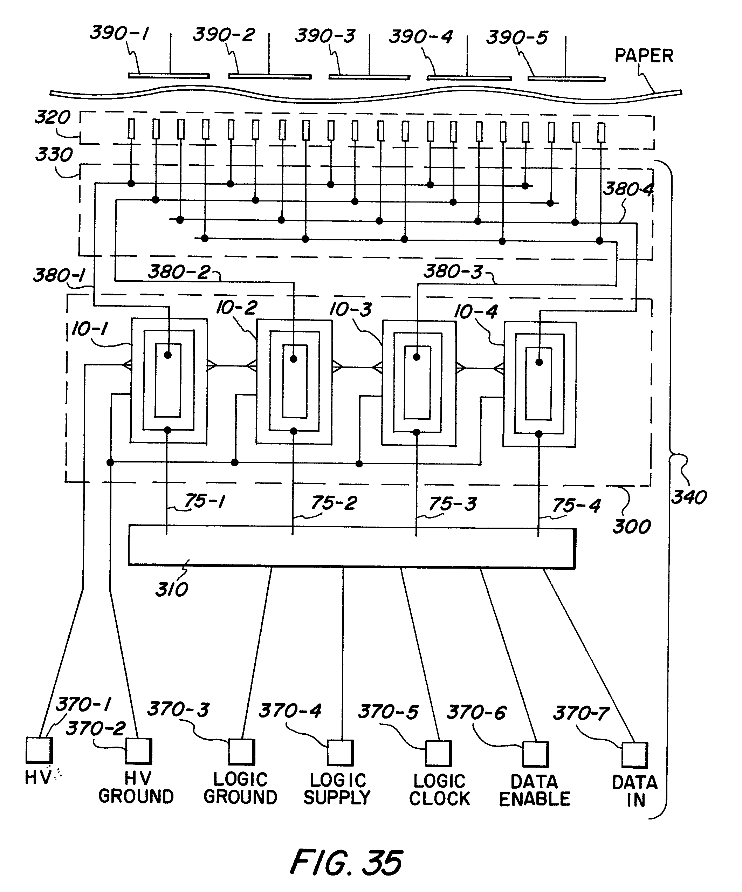

A specific application of a HVMOSFET device 10 is as a HV driver in an array of HV drivers (HVD) 300 with on-chip logic and memory 310, on-chip (or on-substrate) writing styli (or nibs) 320 and interconnect grid 330, to form an electrographic print head 340 such as might be used in an electrostatic printer as shown in Figure 34 for a single print head 340 generally and Figure 35 for a single print head 340 specifically. The print head 340 would be an integrated silicon print head chip or universal building bock for electrographic printers (not shown).

It will be appreciated that an array 350 of print heads 340-1 to 5 on a substrate 360 as shown in Figure 36 is composed of a number of parallel connected identical silicon chips or print heads 340 each containing all the elements of a print head such as the aforementioned nibs 320, drivers 300, logic/memory 310, interconnect 330 and also a relatively small number of inputs 370-1 to 7. As a result, the overall number of HV drivers 10 in an array 300 need no longer be minimized, as traditionally done, but rather, it may be optimized for anyone of the print heads or building block chips 340. All interconnects as represented by the interconnect grid 330 may be individualized with the chips or print heads 340 because of the close proximity of the driver and nib arrays 300, 320. Also, as a result of the relatively small number of nibs per driver, capacitive loading on every driver 10 is minimized thereby giving better performance e.g. higher speed, higher resolution, lower power, and in a specific embodiment such as an electrostatic printer, relatively high resolution and paper speed.

Insomuch as loading capacitance is a relatively severe problem in present embodiment print heads for electrostatic printers, the present invention represents an advance over the prior art. The number of drivers 10 and nibs per chip for an array 320 as well as the on-chip interconnect 330 may be optimized for the driving/logic architecture. Hence, power or speed therefore can be optimized separately.

It is to be appreciated that each chip or print head 340 is electronically independent as to others in the array 340. As a result, a page can be written in multiplaces simultaneously thereby enabling a multi-fold increase in writing speed. It will be further appreciated, that the print head 340 and its utilization in an electrographic printer, are independent of the nibs in an array 320 placing, that is, whether the writing nib array 320 is on the same piece of silicon as the print head 340, or on some supporting substrate.

In a particular embodiment for a print head 340, as shown in Figure 35, high voltage (HV) is applied on input lead 370-1 to HVMOSFET drivers 10-1 to 10-4, HV ground on input lead 370-1, logic ground on input lead 370-3, logic supply (5v) on input lead 370-4, logic clock on input lead 370-5, data enable on input lead 370-6, and data-in on input lead 370-7.

In the operation thereof, a serial bit stream representative of the information or image that is to be printed on paper or other media is loaded into Data-In on input lead 370-7 to a conventional series/parallel shift register (not shown) that is the logic of addressing medium of the logic/memory 310. The bit stream on line 370-7 is received at the serial input of the shift register at a rate determined by the clock signal inputted to the logic-clock input lead 370-5. Conventionally tied to each of the parallel outputs of the shift register selectively for receiving '1's is a separate conventional latch (not shown) or memory which is clocked in a rate also determined by the Logic-clock input lead 370-5. The control data that have been sampled are output from the latch when a data enable signal is received on the input lead 370-6. The latched out signal to the drivers 10 is the Vin control gate signal on lines 75-1 to 4 as described above and shown in Figure 24. It will also be appreciated that the HV ground input lead 370-2 serves a functional equivalent to the ground line 30, and the HV input lead 370-1 serves as a functional equivalent to the HV line 45' also shown in Figure 24. Thus according to the bit make up in the latched shift registers of the logic/memory 310, the array 300 of drivers 101 to 4 that have been cascaded together in parallel can be individually controlled to be either 'on' or 'off' at a given time. Those drivers 10-1 to 4 that are controlled to be on, out on lines 380-1 to 4 are functionally equivalent to the Vo line 45/30' as shown in Figure 24.

The selected signals traverse the interconnect grid 330 for multiplexing into predetermined sets according to the matrix of nodes to predetermined nibs in the styli array 320. The nibs receiving the HV signal become charged one way, while logic (not shown) that is conventional to electrostatic printers places an opposite charge on a selected plate of a set 390-1 to 5 oppositely adjacent to the charged nibs, such that paper or other media transported there between becomes charged to form an image as predetermined by the information embodied in the bit stream, referred to above.

Referring to Figure 36, it will be appreciated that the print head chips 340 can be placed in parallel to form an array 350 with parallel inputs that are common, being tied together thereby providing a minimum number of external inputs. As a result, the print head array 350 could be "N" print heads 340 in length, thus giving a modular approach for a printing line of indefinite length.

CLAIMS:

1. An array of print heads (350) for an electrographic printer having each of the print heads on a chip (340), characterised by

a) logic means (310) operative to receive a bit stream (370-7) representative of an image to the printer for the addressing and latching of the bit stream for selectively outputting as control signals at a predetermined time;

b) driver means (300) operative to receive the control signals from said logic means (310) for generating high-voltage signals;

c) interconnect means (330) operative to receive the high voltage signals from said driver means for multiplexing into given sets according to a predetermined matrix; and

d) styli means (320) operative to receive the multiplexed sets of high voltage signals from said interconnect means for the charging thereof thereby enabling a representation of the image to be transferred to a suitable medium adjacent to the print head array.

2. The array of print heads according to Claim 1 characterised in that said logic means (310) further includes means for receiving the bit stream in series and outputting in parallel.

3. The array of print heads according to Claim 2 characterised in that said logic means further includes memory means for receiving and holding for a predetermined period the parallel bit stream from said series-to-parallel means.

4. The array of print heads according to any preceding claim characterised in that said driver means (300) is an array of high voltage driver MOSFET's (10-1, 10-2 ....) cascaded in parallel.

5. The array of print heads according to any preceding claim, characterised in that said interconnect grid means (330) multiplexes the high voltage signals received from said driver means (300) by noding one signal from said driver means per matrix predetermined set.

6. The array of print heads according to Claim 2 and any claim dependant therefrom, characterised in that said series-to-parallel means

0020163

is a shift register.

7.   The array of print heads according to Claim 3 and any claim dependant therefrom, characterised in that said memory means is a latch.

8.   The array of print heads according to any preceding claim characterised in that said styli means (320) are writing nibs.

9.   The array of print heads according to any preceding claim characterised in that said styli means (320) are on-chip relative to the print head.

10.  The array of print heads according to any of claims 1 to 8, characterised in that said styli means (320) are off-chip relative to the print head.

11.  The  array of print heads according to Claim 4, or any claims dependant therefrom, characterised in that MOSFET has a predetermined load connected thereto.

FIG. 1

FIG. 2

FIG. 3

FIG. 4

FIG. 5

FIG. 6

FIG. 7

FIG. 8

FIG. 9

10

25    GATE    70    SOURCE PLATE

FIELD PLATE

80    DRAIN AREA    20

35

25    25

25    PLATE    25

## FIG. 10

10    $V_{GI}$    $V_{G2}$    $V_D$    $V_{G2}$    $V_{GI}$

$V_S$    75    85    45    85    75    $V_S$

30    80    40    80    30

25    70    70    25    20

20    N+    P    50    55    N+    55    50    P    N+    92

90    35    90

210    51    15    51

## FIG. 11

**FIG. 12**

FIG. 13

FIG.14

FIG.16

0020163

FIG. 15

N++  N+  N  N

35-2  35-3  35-4  35

35-1  35

P-  15

51  55

220-1  220-2  220-3

45  40  40'  55'

85-1  85-2  85-3  85-4

80'-1  80'-2  80'-3

80-1  80-2  80-3

220-1  70  75  50  90

N+  25  20  30

FIG. 17

FIG. 18

FIG.19

FIG.20

FIG.21

FIG. 23

FIG. 22

*FIG. 24*

*FIG. 25*

FIG. 26

FIG. 27

FIG. 28

*FIG. 29*

*FIG. 30*

*FIG. 31*

FIG.32

FIG.33

FIG.33A

320

← W →

340

330  INTERCONNECT GRID

300  H V D 'S

310  LOGIC & MEMORY

370

**FIG. 34**

350  340-1  340-2  340-3  340-4  340-5

360

**FIG. 36**

FIG. 35

## DOCUMENTS CONSIDERED TO BE RELEVANT

| Category | Citation of document with indication, where appropriate, of relevant passages | Relevant to claim |
|---|---|---|
| | <u>DE - A - 2 738 641</u> (SHARP K.K.)  * Page 3, paragraph 1- page 13, paragraph 1; figures 1-7 *  -- | 1-6,9 |
| A | <u>US - A - 3 813 513</u> (I.B.M.)  * Abstract; figures 4-9D; column 4, line 20 - column 8, line 33 *  -- | |
| A | IEEE INTERNATIONAL SOLID STATE CIRCUITS CONFERENCE, vol. XXII, February 1979, pages 12,13 New York, U.S.A. KAZUHIDE KIUCHI et al.: "A 65mW 128K EB-ROM"  * Pages 12,13 *  -- | |
| A | ELECTRONICS, vol. 51, no. 26, 21st December 1978, pages 31-32 New York, U.S.A. "Simple cell design for dynamic RAM scraps capacitor"  * pages 31,32 *  -- | |
| A | <u>DE - A - 2 740 702</u> (SIEMENS)  * Whole document *  ---- | |

**CLASSIFICATION OF THE APPLICATION (Int. Cl. ³)**

H 01 L 27/10
G 03 G 15/00
      15/044
      15/048
      15/22
      15/32
B 41 J  3/16

**TECHNICAL FIELDS SEARCHED (Int.Cl. ³)**

H 01 L 27/10
G 03 G 15/00
      15/044
      15/048
      15/22
      15/32
B 41 J  3/16

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 10-09-1980 | CHOMENTOWSKI |

EPO Form 1503.1  06.78